# EUROPÄISCHE PATENTSCHRIFT

(11) **EP 1 019 881 B1**
(45) Veröffentlichungstag und Bekanntmachung des Hinweises auf die Patenterteilung: **27.02.2002**
(21) Anmeldenummer: 98958169.9
(22) Anmeldetag: 24.09.1998
(51) Int. Cl.: G08B 29/06, G01R 31/02

(54) **DIGITALEINGABEEINHEIT MIT MITTELN ZUR DRAHTBRUCHERKENNUNG**
DIGITAL OUTPUT UNIT WITH MEANS FOR DETECTING WIRE BREAKAGE
UNITE D'ENTREE NUMERIQUE AVEC MOYENS DE RECONNAISSANCE DE RUPTURES DE FILS

(30) Priorität: 29.09.1997 DE 29717369 U
(43) Veröffentlichungstag der Anmeldung: 19.07.2000
(73) Patentinhaber: SIEMENS AKTIENGESELLSCHAFT, 80333 München (DE)
(72) Erfinder: MAIER, Willi, D-77728 Oppenau (DE)
(86) Internationale Anmeldenummer: DE9802857
(87) Internationale Veröffentlichungsnummer: WO9917262

(56) Entgegenhaltungen:
- EP-A- 0 735 375
- CH-A- 676 393
- KIRK K: "REMOTE LOGIC DRIVE" NEW ELECTRONICS, Bd. 9, Nr. 22, 16. November 1976, Seite 19 XP002032864

## Beschreibung

Die Erfindung betrifft eine Digitaleingabeeinheit mit Mitteln zur Drahtbrucherkennung und mit mindestens einem Eingangskanal, welchem über eine Leitung ein Eingangssignal zuführbar ist, welches potentialtrennende Mittel einer Auswerteeinheit übertragen, die Pegelzustände des Eingangssignals oberhalb einer ersten Schwelle einer log. "1" und Pegelzustände zwischen einer Spannung größer 0 V und unterhalb einer zweiten Schwelle, welche kleiner als die erste Schwelle ist, einer log. "0" zuordnet.

Eine derartige Digitaleingabeeinheit ist aus dem Siemens-Katalog ST 70, Ausgabe 1997, Seiten 4/16 und 4/17 bekannt. Zur Potentialtrennung ist gewöhnlich für jeden Eingangskanal ein erster und ein zweiter Optokoppler vorgesehen, von denen einer zur Übertragung des Eingangssignals, d. h. zur Übertragung der Statusinformation log. "0" und log. "1", und der andere für die Übertragung einer Drahtbruchinformation zu einer Drahtbruchüberwachungseinheit, welche die an die Eingangsschaltung angeschlossenen Leitungen überwacht, vorgesehen ist.

Aus dem Dokument EP-A-0 735 375 ist ebenso eine Schaltung bekannt, die den Benutzer erkennen läßt, wenn es im Eingangskreis zu einem Drahtbruch gekommen ist.

Der vorliegenden Erfindung liegt die Aufgabe zugrunde, in einer Digitaleingabeeinheit der eingangs genannten Art die Übertragung der Status- und der Drahtbruchinformation zu vereinfachen.

Diese Aufgabe wird durch die im kennzeichnenden Teil des Anspruchs 1 angegebenen Maßnahmen gelöst.

Vorteilhaft ist, daß durch die erfindungsgemäße Digitaleingabeeinheit lediglich ein Optokoppler zur Übertragung der Status- und der Drahtbruchinformation erforderlich ist. Insbesondere in Digitaleingabeeinheiten mit mehreren Eingangskanälen wird dadurch das EMV-Verhalten erheblich verbessert.

Weitere vorteilhafte Ausgestaltungen der Erfindung ergeben sich aus den Unteransprüchen.

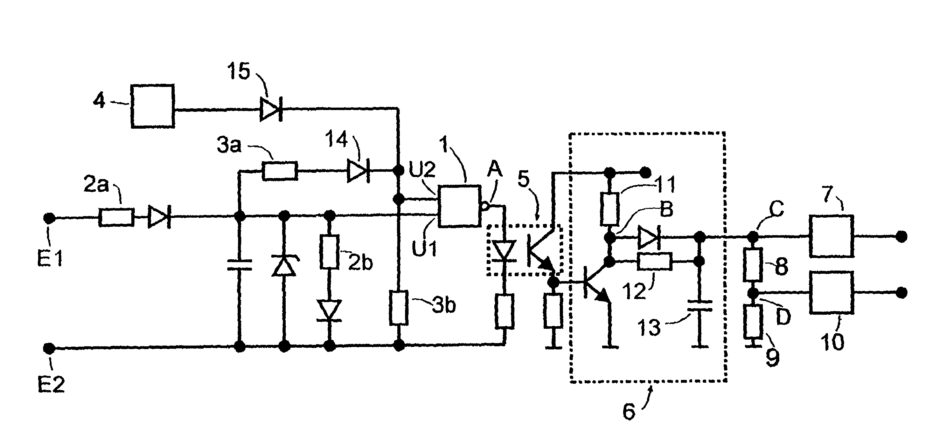

Die Erfindung wird nachfolgend anhand eines Ausführungsbeispiels unter Bezugnahme auf die einzige Figur der Zeichnung näher erläutert. Die Figur der Zeichnung zeigt eine Eingangsschaltung eines Eingangskanals einer Digitaleingabeeinheit.

Der Eingangsschaltung ist über Eingangsklemmen E1, E2 ein Eingangssignal zuführbar, dessen Pegelzustände oberhalb einer ersten Schwelle von 8 V einem Signal log. "1", zwischen einer Spannung von 0 V und dieser Schwelle von 8 V einem Signal log. "0" und unterhalb einer zweiten Schwelle von 3 V einem Signal log. "0" mit Drahtbruch entsprechen. Das Eingangssignal wird über einen ersten Spannungsteiler 2a, 2b an einen ersten Eingang U1 eines mit einer Spannung von 5 V betreibbaren NOR-Verknüpfungsgliedes 1 und das über eine Diode 14 und einen zweiten Spannungsteiler 3a, 3b geführte Eingangssignal an einen zweiten Eingang U2 dieses Verknüpfungsgliedes 1 geleitet. Ein Taktgenerator 4 beaufschlagt über eine Diode 15 den zweiten Eingang U2 zusätzlich mit einem Taktsignal, wobei das NOR-Verknüpfungsglied 1 an seinem Ausgang A in Abhängigkeit des Eingangssignalpegels und des Taktsignalpegels ein Verknüpfungssignal log. "0", log. "1" oder ein taktsignalfrequentes Verknüpfungssignal anlegt. Dieses Verknüpfungssignal überträgt ein Optokoppler 5 einer Auswerteeinheit, die eine Verstärker- und Filtereinheit 6, einen Spannungsteiler 8, 9 und einen ersten und einen zweiten Komparator 7, 10 umfaßt. Ein Filter 12, 13 der Verstärker- und Filtereinheit 6 filtert das Verknüpfungssignal und schaltet das gefilterte Verknüpfungssignal dem ersten Komparator 7 und das über den Spannungsteiler 8, 9 geführte gefilterte Verknüpfungssignal dem zweiten Komparator 10 auf. Die Komparatoren 7, 10 vergleichen jeweils das anliegende Verknüpfungssignal mit einem Referenzsignal und erzeugen binäre Ausgangssignale, wobei - wie im folgenden noch näher erläutert wird - der Komparator 10 die Statusinformation, also ein Ausgangssignal log. "0", log. "1", und der Komparator 7 ein Ausgangssignal "Kein Drahtbruch" anzeigt.

Im folgenden wird die Funktions- und Wirkungsweise der Eingangsschaltung näher erläutert.
Es wird zunächst angenommen, daß ein Eingangssignal log. "1" an den Eingangsklemmen E1, E2 anliegt, was im vorliegenden Beispiel einem Spannungspegel größer 8 V entspricht. An beiden Eingängen U1, U2 des NOR-Verknüpfungsgliedes 1 liegt aufgrund der Dimensionierung der Spannungsteiler 2a, 2b; 3a, 3b - der Taktsignalpegel kann sich wegen der ODER-Verknüpfung der Dioden 14, 15 nicht "durchsetzen" und der Eingang U2 des NOR-Verknüpfungsgliedes 1 "erkennt" ein statisches Signal log. "1" - eine Spannung größer als die Schwellenspannung von 2,5 V des NOR-Verknüpfungsgliedes 1, wodurch das NOR-Verknüpfungsglied 1 am Ausgang eine log. "0" erzeugt. Der Transistor des Optokopplers 5 sperrt, wodurch am Verbindungspunkt B der Verstärker- und Filtereinheit 6 eine log. "1" und an den Eingängen C, D der Komparatoren 7, 10 ebenfalls eine log. "1" anliegt. Die Komparatoren 7, 10 erzeugen an ihren Ausgängen jeweils ein Ausgangssignal log. "1", was darauf hinweist, daß kein Drahtbruch vorliegt und das Ausgangssignal einer log. "1" entspricht.

Es wird nun angenommen, daß ein Eingangssignal log. "0" und "Kein Drahtbruch" an den Eingangsklemmen E1, E2 anliegt, was im vorliegenden Beispiel einem Spannungspegel größer 3 V und kleiner 8 V entspricht. Dieses Signal liegt am ersten Eingang U1 des NOR-Verknüpfungsgliedes 1 als log. "1" an. Am zweiten Eingang U2 setzt sich aufgrund der Dimensionierung des Spannungsteilers 3a, 3b das Taktsignal durch, so daß der Eingang U2 des NOR-Verknüpfungsgliedes 1 den Takt "erkennt". Das NOR-Verknüpfungsglied 1 erzeugt an seinem Ausgang A und dadurch am Verbindungspunkt B der Verstärker- und Filtereinheit 6 ein taktsignalfrequentes Signal, welches ein Filter 12, 13 der Verstärker- und Filtereinheit 6 filtert. Der Gleichspannungsanteil dieses gefilterten Signals am Eingang C des Komparators 7 bewirkt am Ausgang des Komparators 7 eine log. "1" und das über den Spannungsteiler 8, 9 geführte gefilterte Signal am Eingang D des Komparators 10 bewirkt an dessen Ausgang eine log. "0". Das Signal log. "1" am Ausgang des Komparators 7 weist darauf hin, daß kein Drahtbruch vorliegt, und das Signal log. "0" am Ausgang des Komparators 10, daß das Ausgangssignal einer log. "0" entspricht.

Es wird nun angenommen, daß die Zuleitung (nicht dargestellt) zur Eingangsklemme E1 unterbrochen ist, wodurch die Eingangsspannung an den Eingangsklemmen E1, E2 0 V ist. Das NOR-Verknüpfungsglied erzeugt an seinem Ausgang A eine log. "1", wodurch der Transistor des Optokopplers 5 durchschaltet. Sowohl am Verbindungspunkt B als auch an den Eingängen C, D der Komparatoren 7, 10 liegt eine log. "0" an. Das Signal log. "0" am Ausgang des Komparators 7 weist auf einen Drahtbruch hin und zeigt somit an, daß das Signal log. "0" am Ausgang des Komparators 10 aufgrund des fehlenden Eingangssignals und nicht durch einen einer log. "0" entsprechenden Eingangssignalpegel bewirkt wird.

## Patentansprüche

1. Digitaleingabeeinheit mit Mitteln zur Drahtbrucherkennung und mit mindestens einem Eingangskanal, welchem über eine Leitung ein Eingangssignal zuführbar ist, welches potentialtrennende Mittel (5) zu einer Auswerteeinheit (6, 7, 8, 9, 10) übertragen, die Pegelzustände des Eingangssignals oberhalb einer ersten Schwelle einer log. "1" und Pegelzustände zwischen einer Spannung größer 0 V und unterhalb einer zweiten Schwelle, welche kleiner als die erste Schwelle ist, einer log. "0" zuordnet,
**dadurch gekennzeichnet,**
- **daß** die Digitaleingabeeinheit mit einem Taktgenerator (4) versehen ist, welcher ein Taktsignal erzeugt, dessen Pegel kleiner als die-erste und größer als die zweite Schwelle ist,
- **daß** zur Erzeugung eines Verknüpfungssignals der Eingangskanal eine nach Art einer NOR-Verknüpfung betreibbare Verknüpfungsschaltung (1) aufweist, deren erstem Eingang (U1) das Eingangssignal und deren zweitem Eingang (U2) das Taktsignal, welchem das über einen Spannungsteiler (2, 3) geführte Eingangssignal überlagert ist, zuführbar ist,
- **daß** die Auswerteeinheit (6, 7, 8, 9, 10) den Gleichspannungsanteil des Verknüpfungssignals bewertet und entsprechend der Bewertung ein Ausgangssignal in Form einer Statusinformation log. "0" oder log. "1" oder ein Ausgangssignal "Drahtbruch" erzeugt.

2. Digitaleingabeeinheit nach Anspruch 1, **dadurch gekennzeichnet,**
- **daß** die Auswerteeinheit (6, 7, 8, 9, 10) einen Filter (12, 13) aufweist, welchem das Verknüpfungssignal zuführbar ist,
- **daß** die Auswerteeinheit (6, 7, 8, 9, 10) ferner einen Spannungsteiler (8, 9) und einen ersten und einen zweiten Komparator (7, 10) aufweist, die jeweils ein binäres Ausgangssignal erzeugen, wobei dem ersten Komparator (7) das gefilterte Verknüpfungssignal und dem zweiten Komparator (10) das über den Spannungsteiler (8, 9) geführte gefilterte Verknüpfungssignal zuführbar ist,
- **daß** das Ausgangssignal eines Komparators (10) zur Anzeige der Statusinformation log. "0" oder log. "1" und das Ausgangssignal des anderen Komparators (7) zur Anzeige eines Drahtbruches vorgesehen ist.

3. Digitaleingabeeinheit nach Anspruch 1 oder 2, **dadurch gekennzeichnet, daß** die Digitaleingabeeinheit mit mehreren Eingangskanälen versehen ist, welchen jeweils das Taktsignal des Taktgenerators (4) zuführbar ist.

## Claims

1. Digital input unit with means for detecting wire breakage and with at least one input port to which an input signal can be supplied via a line, which input signal transmits buffering means (5) to an evaluation unit (6, 7, 8, 9, 10) which allocates level states of the input signal above a first threshold to a log "1" and level states between a voltage greater than 0 V and below a second threshold which is smaller than the first threshold to a log "0", **characterised in that**
- the digital input unit is provided with a clock (4), which produces a clock signal, the level of which is smaller than the first and greater than the second threshold,
- **in that** to produce a logic signal the input port has a logic circuit (1) which can be operated in the manner of an NOR logic, to the first input (U1) of which the input signal can be supplied and to the second input (U2) of which the clock signal can be supplied on which the input signal guided via a voltage divider (2, 3) is superimposed,
- **in that** the evaluation unit (6, 7, 8, 9, 10) evaluates the direct voltage content of the logic signal and according to the evaluation produces an output signal in the form of a status information log "0" or log "1" or an output signal "wire breakage".

2. Digital input unit according to claim 1, **characterised in that**
- the evaluation unit (6, 7, 8, 9, 10) has a filter (12, 13) to which the logic signal can be supplied,
- **in that** the evaluation unit (6, 7, 8, 9, 10) also has a voltage divider (8, 9) and a first and second comparator (7, 10) which respectively produce a binary output signal, wherein the filtered logic signal can be supplied to the first comparator (7) and the filtered logic signal guided via the voltage divider (8, 9) can be supplied to the second comparator (10),
- **in that** the output signal of a comparator (10) is provided for displaying the status information log "0" or log "1" and the output signal of the other comparator (7) is provided for displaying a wire breakage.

3. Digital input unit according to claim 1 or 2, **characterised in that** the digital input unit is provided with a plurality of input ports, to which the clock signal of the clock (4) can be supplied respectively.

## Revendications

1. Unité d'entrée numérique, ayant des moyens de reconnaissance de ruptures de fils et au moins un canal d'entrée, auquel peut être envoyé, par un conducteur, un signal d'entrée, que des moyens (5) de séparation de potentiel envoient à une unité (6, 7, 8, 9, 10) d'analyse, qui associe des états de niveau du signal d'entrée supérieurs à un premier seuil à un log. "1" et des états de niveau entre une tension supérieure à 0 V et inférieure à un deuxième seuil, qui est inférieure au premier seuil, à un log. "0"
**caractérisée en ce que**,
- l'unité d'entrée numérique est munie d'un générateur (4) de cadence, qui produit un signal de cadence dont le niveau est inférieur au premier seuil et supérieur au deuxième seuil,
- pour produire un signal logique, le canal d'entrée comporte un circuit (1) logique pouvant fonctionner à la manière d'un élément logique NI, à la première entrée (U1) duquel peut être envoyé le signal d'entrée, et à la deuxième entrée (U2) duquel peut être envoyé le signal de cadence, auquel est superposé le signal d'entrée envoyé par un diviseur (2, 3) de tension,
- l'unité (6, 7, 8, 9, 10) d'analyse évalue la composante de tension continue du signal logique et produit, en fonction de l'évaluation, un signal de sortie sous la forme d'une information de statut log. "0" ou log. "1", ou un signal de sortie "ruptures de fils".

2. Unité d'entrée numérique suivant la revendication 1, **caractérisée en ce que**,
- l'unité (6, 7, 8, 9, 10) de calcul comporte un filtre (12, 13) auquel le signal logique peut être envoyé,
- l'unité (6, 7, 8, 9, 10) d'analyse comporte en outre un diviseur (8, 9) de tension et un premier et un deuxième comparateur (7, 10), qui produisent respectivement un signal binaire de sortie, le signal logique filtré pouvant être envoyé au premier comparateur (7), et le signal logique filtré envoyé par les diviseurs (8, 9) de tension pouvant être envoyé au deuxième comparateur (10),
- le signal de sortie d'un comparateur (10) est prévu pour indiquer la formation de statut log. "0" ou log. "1", et le signal de sortie de l'autre comparateur (7) pour indiquer une rupture de fils.

3. Unité d'entrée numérique suivant la revendication 1 ou 2, **caractérisé en ce que** l'unité d'entrée numérique, est munie de plusieurs canaux d'entrée, auxquels peut être envoyé respectivement le signal de cadence du générateur (4) de cadence.
